# EUROPEAN PATENT SPECIFICATION

(11) **EP 2 400 560 B1**
(45) Date of publication and mention of the grant of the patent: **25.03.2020**
(21) Application number: 10743760.0
(22) Date of filing: 17.02.2010
(51) Int. Cl.: H01L 31/02, H01L 31/042, H01L 31/05

(54) **SOLAR BATTERY MODULE**
SOLARBATTERIEMODUL
MODULE DE CELLULES SOLAIRES

(30) Priority: 17.02.2009 JP 2009033843
(43) Date of publication of application: 28.12.2011
(73) Proprietor: Shin-Etsu Chemical Co., Ltd., Tokyo 100-0004 (JP)
(72) Inventor: MURAKAMI Takashi, Tokyo 100-0004 (JP); OTSUKA Hiroyuki, Annaka-shi Gunma 379-0195 (JP); WATABE Takenori, Annaka-shi Gunma 379-0195 (JP); ISHIKAWA Naoki, Annaka-shi Gunma 379-0195 (JP)
(74) Representative: Mewburn Ellis LLP
(86) International application number: PCT/JP2010/052320
(87) International publication number: WO 2010/095634

(56) References cited:
- WO-A1-2008/016043
- DE-A1-102006 021 804
- JP-A- 11 354 822
- JP-A- 2000 315 811
- JP-A- 2002 026 361
- JP-A- 2007 201 331
- US-A- 3 370 986

## Description

### TECHNICAL FIELD

This invention relates to a solar cell module comprising solar cells in the form of semiconductor devices.

### BACKGROUND ART

A solar cell module fabricated from crystalline solar cells is generally manufactured by providing solar cells based solely on substrates of one conductivity type and connecting the cells in series for the purpose of increasing the voltage. In this event, if cells each have an electrode of first polarity on a light-receiving surface side and an electrode of second polarity (opposite to the first polarity) on a non-light-receiving surface side are used, then the electrode of first polarity on the light-receiving surface side must be connected to the electrode of second polarity on the non-light-receiving surface side by a conductor containing solder and other components (referred to as "tab wire") in order to achieve series connection. Those electrodes which are connected by the tab wire are electrodes of a relatively large width (about 1 to 3 mm) and generally known as bus-bar electrodes.

In the conventional solar cell module mentioned above, an attempt is made to arrange solar cells as closely as possible to each other in order to increase the module conversion efficiency. However, because of the presence of the tab wire connecting the electrodes on the light-receiving and non-light-receiving surface sides, an attempt to reduce the spacing between solar cells to a distance of 3.0 mm or less encounters a problem of cell edge failure due to the bending stress of the tab wire. This causes a reduction of the packing density of solar cells relative to the area of the solar cell module.

One approach to this problem is by reducing the thickness of the tab wire itself simply for the purpose of reducing the bending stress of the tab wire, although another problem of increased wiring resistance arises. Another approach is described, for example, in JP-A 2008-147260 (Patent Document 1), proposing a solar cell module in which a tab wire is provided with a pre-bent portion, and the tab wire is connected such that the bent portion is disposed between adjacent cells, thereby reducing the bending stress of the tab wire and preventing cell edge failure.

This method, however, has drawbacks that a tab wire having a special bent portion must be prepared, and the presence of the bent portion increases the connection length of the tab wire, thus exacerbating the fill factor of the solar cell module.

Document DE 10 2006 021 804 A1 discloses a solar cell module comprising in an alternating arrangement first solar cells having a p-type substrate and second solar cells having an n-type substrate. The first and second solar cells are connected in series by conductive paths.

### CITATION LIST

### PATENT DOCUMENT

Patent Document 1: JP-A 2008-147260

### SUMMARY OF INVENTION

### PROBLEMS TO BE SOLVED BY THE INVENTION

An object of the invention, which has been made under the aforementioned circumstances, is to provide a solar cell module which is improved in module conversion efficiency by increasing the packing density of solar cells relative to the area of the solar cell module.

### MEANS FOR SOLVING THE PROBLEMS

Making extensive investigations to attain the above object, the inventors have found that when a first solar cell comprising a substrate of first conductivity type having a light-receiving surface and a non-light-receiving surface and electrodes of opposite polarity formed on the light-receiving and non-light-receiving surfaces, respectively, and a second solar cell comprising a substrate of second conductivity type opposite to the first conductivity type having a light-receiving surface and a non-light-receiving surface and electrodes of opposite polarity formed on the light-receiving and non-light-receiving surfaces, respectively, are alternately arranged, a solar cell module is constructed in which the first solar cell having an electrode of first polarity and the second solar cell having an electrode of second polarity opposite to the first polarity are juxtaposed in a common plane. This arrangement ensures that the first and second solar cells are connected in series by connecting the electrodes on the light-receiving surface to each other and the electrodes on the non-light-receiving surface to each other with tab wires, and the cells are closely arranged at a spacing of 3.0 mm or less, whereby the packing density of solar cells relative to the area of the solar cell module may be increased, leading to improved module conversion efficiency. The arrangement facilitates attachment of the tab wires and eliminates the stress due to the tab wires, preventing cell edge failure and increasing the yield of manufacture, which ensures fabrication of a highly reliable solar cell module. The invention is predicated on these findings.

It is noted that of the electrodes on the light-receiving and non-light-receiving surfaces, thin electrodes of about 50 to 200 µm wide which are formed on the solar cell front surface across bus-bar electrodes for collecting outputs are referred to as "finger electrodes", and relatively thick electrodes of about 1 to 3 mm wide for taking out the output collected by the finger electrodes are referred to as "bus-bar electrodes".

Accordingly, the invention provides a solar cell module as defined in independent claim 1 and a method for manufacturing a solar cell module as defined in independent claim 7. Further preferred embodiments are detailed in the appended claims.

### ADVANTAGEOUS EFFECTS OF INVENTION

The solar cell arrangement and interconnecting method according to the invention permit the packing density of solar cells relative to the area of the solar cell module to be increased, whereby the module conversion efficiency is improved. Additionally, since the stress applied from tab wires to the edge of solar cells can be reduced as compared with the prior art method, a highly reliable solar cell module can be fabricated in improved manufacture yields.

### BRIEF DESCRIPTION OF DRAWINGS

FIG. 1 illustrates an exemplary series connection of solar cells in a prior art solar cell module, FIG. 1a being a cross-sectional view and FIG. 1b being a plan view of the light-receiving surface side.
FIG. 2 illustrates an exemplary series connection of solar cells in a solar cell module according to the invention, FIG. 2a being a cross-sectional view and FIG. 2b being a plan view of the light-receiving surface side.
FIG. 3 is a plan view of the light-receiving surface side, showing an exemplary interconnection of an overall prior art solar cell module.
FIG. 4 is a plan view of the light-receiving surface side, showing an exemplary interconnection of an overall solar cell module according to the invention.

### DESCRIPTION OF EMBODIMENT

Now, embodiments of the invention are described in detail with reference to the drawings although the invention is not limited to the illustrated embodiments. Throughout the drawings for illustrating embodiments, like characters represent parts having the same function and iteration of their description is omitted. For ease of understanding, drawing is made in exaggeration with respect to the spacing between solar cells and the thickness thereof. For convenience sake, finger electrodes are omitted.

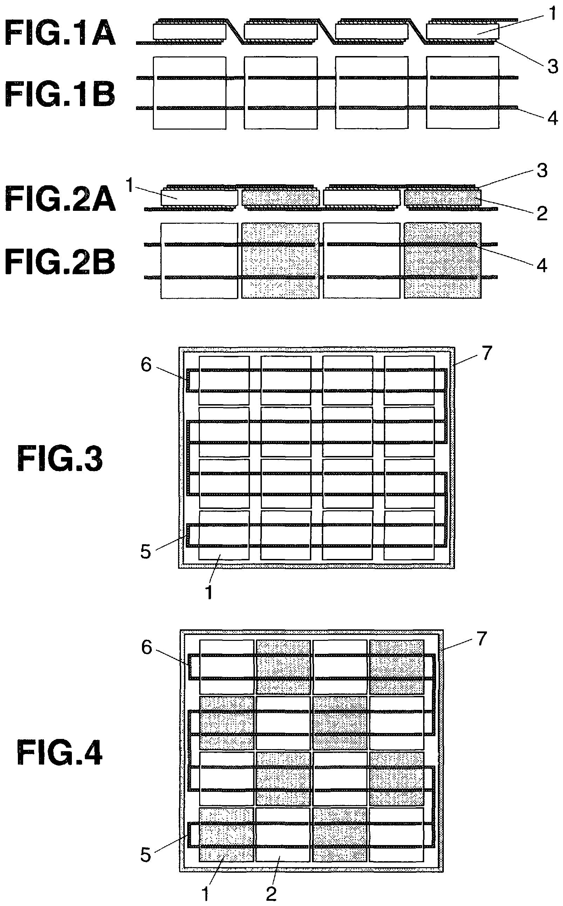

The invention is directed to a solar cell module in which a first solar cell(s) comprising a first conductivity type substrate having a light-receiving surface and a non-light-receiving surface and electrodes of opposite polarity formed on the light-receiving and non-light-receiving surfaces, respectively, and a second solar cell(s) comprising a second conductivity type substrate having a light-receiving surface and a non-light-receiving surface and electrodes of opposite polarity formed on the light-receiving and non-light-receiving surfaces, respectively, are alternately arranged. This solar cell module is constructed as shown in FIG. 2 wherein solar cells 1 having a first conductivity type substrate and solar cells 2 having a second conductivity type substrate are alternately arranged, and bus-bar electrodes 3 are connected by tab wires 4. Herein, the conductivity type of the substrate of the first solar cell is opposite to the conductivity type of the substrate of the second solar cell. For example, when the former is n-type, the latter is p-type. Also, the polarity of the electrode on the light-receiving surface of the substrate of the first solar cell is identical with the polarity of the electrode on the non-light-receiving surface of the substrate of the second solar cell, while the electrode on the non-light-receiving surface of the substrate of the first solar cell and the electrode on the light-receiving surface of the substrate of the second solar cell are of the same polarity. In the embodiment of the invention, as shown in FIG. 2b, for example, when the first solar cell is disposed with the light-receiving surface of its substrate facing upward, the second solar cell is disposed with the light-receiving surface of its substrate facing upward, so that the electrode on the light-receiving surface of the first solar cell and the electrode on the light-receiving surface of the second solar cell may be linearly connected in a common plane without a bend.

In this embodiment, the conductivity type of substrate, impurity diffusion layer, antireflective coating and other components of the solar cells used herein may be in accord with well-known examples. The solar cells may be prepared by the well-known method described in JP-A 2001-77386.

The semiconductor substrate of which the solar cells are constructed according to the invention may be, for example, a p- or n-type single crystal silicon substrate, p-or n-type polycrystalline silicon substrate, non-silicon compound semiconductor substrate or the like. For the single crystal silicon substrate, as-cut single crystal {100} p-type silicon substrates in which high purity silicon is doped with a Group III element such as boron or gallium to provide a resistivity of 0.1 to 5 Ω-cm may be used. Similar n-type silicon substrates doped with a Group V element such as phosphorus, antimony or arsenic are also useful.

With respect to the purity of the single crystal silicon substrate used herein, substrates with a lower concentration of metal impurities such as iron, aluminum and titanium are preferred in that higher efficiency solar cells can be fabricated using longer lifetime substrates. The single crystal silicon substrate may be prepared by any methods including the CZ and FZ methods. Herein, metallic grade silicon which is previously purified by a well-known process such as the Siemens process may also be used in the above method.

The thickness of semiconductor substrate is preferably 100 to 300 µm, and more preferably 150 to 250 µm, for a balance of the cost and yield of substrate, and conversion efficiency. If the resistivity of semiconductor substrate is lower than the above-defined range, the distribution of conversion efficiency of solar cells may become narrower, but the crystal cost may be high because of a limitation on ingot pulling. If the resistivity is higher than the range, the distribution of conversion efficiency of solar cells may become broader, but the crystal cost may be low.

In the embodiment of the invention, the first conductivity type may be either n-type or p-type. The second conductivity type may be p-type when n-type is selected for the first conductivity type, or n-type when p-type is selected for the first conductivity type.

Additionally, the substrate surface is preferably provided with microscopic asperities known as "texture." The texture is an effective means for reducing the surface reflectance of solar cells. The texture may be readily provided by dipping in a hot alkali aqueous solution such as sodium hydroxide.

As to the impurity diffusion layer, the impurity source used may be selected from Group V elements such as phosphorus, arsenic and antimony and Group III elements such as boron, aluminum and gallium. In one example, an impurity diffusion layer may be formed by the vapor phase diffusion process using phosphorus oxychloride for phosphorus diffusion, for instance. In this example, heat treatment is preferably carried out in an atmosphere of phosphorus oxychloride or the like at 850 to 900°C for 20 to 40 minutes. Also preferably the impurity diffusion layer has a thickness of 0.1 to 3.0 µm, and more preferably 0.5 to 2.0 µm. If the impurity diffusion layer is too thick, there may be available more sites where electrons and holes generated are recombined, leading to a lowering of conversion efficiency. If the impurity diffusion layer is too thin, there are less sites where electrons and holes generated are recombined, but the transverse flow resistance of current flowing through the substrate to the collector electrode may be increased, leading to a lowering of conversion efficiency. Diffusion of boron, for example, may be effected by applying a commercially available boron-containing coating agent, drying, and heat treating at 900 to 1050°C for 20 to 60 minutes to form a diffusion layer.

In conventional silicon solar cells, a p-n junction must be formed solely on the light-receiving surface. To this end, a suitable means for avoiding formation of p-n junction on the back surface is preferably employed, for example, by stacking two substrates together prior to diffusion, or by forming a SiO₂ film or SiNx film as a diffusion mask on the back surface prior to diffusion. Besides the vapor phase diffusion method, the impurity diffusion layer may also be formed by another technique such as screen printing or spin coating.

The antireflective film is preferably a SiNx film formed using a plasma CVD system or the like, or a multilayer film including a SiO₂ film resulting from thermal oxidation and a SiNx film formed as above. Its thickness is preferably 70 to 100 nm.

On the semiconductor substrate thus obtained, electrodes are formed using the screen printing technique or the like. The shape of electrodes is not particularly limited. The width of bus-bar electrodes is typically 1 to 3 mm, and the number of bus-bar electrodes is preferably 1 to 4, and more preferably 2 to 3 on each surface. Where a plurality of electrodes are formed on one surface, the electrodes are preferably formed to extend parallel to each other.

In the screen printing technique, a conductive paste obtained by mixing conductive particles such as aluminum powder or silver powder, glass frit, organic binder and the like is screen printed. After printing, the paste is baked at 700 to 800°C for 5 to 30 minutes to form electrodes. Electrode formation by the printing technique is preferred although electrodes may also be prepared by evaporation and sputtering techniques. Moreover, electrodes on the light-receiving and non-light-receiving surfaces may be baked at a time. In this way, an electrode of first polarity is formed on the light-receiving surface of the first solar cell having a first conductivity type substrate and an electrode of second polarity opposite to the first polarity is formed on the non-light-receiving surface of the first solar cell. Similarly, an electrode of second polarity is formed on the light-receiving surface of the second solar cell having a second conductivity type substrate and an electrode of first polarity is formed on the non-light-receiving surface of the second solar cell. In an example wherein a n-type semiconductor substrate is selected as the first conductivity type substrate and a p-type semiconductor substrate is selected as the second conductivity type substrate, the electrode of first polarity is a negative electrode and the electrode of second polarity is a positive electrode.

In the solar cell module of the invention, at least one first solar cell and at least one second solar cell, both defined as above, are alternately connected in series and/or in parallel. The thus connected solar cells may be encapsulated with a transparent resin such as ethylene-vinyl acetate (EVA) copolymer, to complete a solar cell module. Moreover, the module may be formed to any of a protected structure which is formed using a substrate as in conventional modules or a film as in conventional modules along with the encapsulating resin, a super-straight structure, a substrate structure, and a glass package structure. Additionally, a frame may be attached for providing protection around the module. Such a solar cell module may be manufactured by any well-known methods, for example, the method of JP-A H09-51117.

One preferred embodiment of the solar cell module of the invention is described in detail with reference to the drawings. FIG. 1 illustrates an exemplary series connection of solar cells in a conventional solar cell module, and FIG. 2 illustrates an exemplary series connection of solar cells in a solar cell module according to the invention. FIGS. 1a and 2a are cross-sectional views, and FIGS. 1b and 2b are plan views as viewed from the light-receiving surface side. Illustrated in FIGS. 1 and 2 are first solar cells 1 having a first conductivity type substrate, second solar cells 2 having a second conductivity type substrate, bus-bar electrodes 3, and tab wires 4.

The conventional solar cell module of FIG. 1 consists of solar cells having a first conductivity type substrate. As such, the bus-bar electrode on the light-receiving surface side and the bus-bar electrode on the non-light-receiving surface side are connected by tab wires to achieve series connection. An attempt to arrange solar cells as closely as possible for the purpose of increasing the module conversion efficiency can result in a cell edge failure due to the bending stress of tab wires.

On the other hand, the solar cell module of the invention shown in FIG. 2 is constructed such that solar cells 1 having a first conductivity type substrate and solar cells 2 having a second conductivity type substrate are alternately arranged. Thus cells having electrodes of first polarity and cells having electrodes of second polarity are juxtaposed on a common plane, allowing electrodes on the light-receiving surface or electrodes on the non-light-receiving surface to be connected to each other by tab wires to achieve series connection. As a result, adjacent cells may be closely arranged at a spacing of 3.0 mm or less, especially 1.0 mm or less. If the spacing between cells is too large, the packing density of solar cells relative to the area of the solar cell module may be reduced, resulting in a lowering of module conversion efficiency. Although a shorter spacing between cells is desirable, a spacing of at least 0.1 mm is preferred because a too close spacing allows for contact between cells, causing fissure or chipping. In another embodiment wherein an enclosure frame is attached, the spacing between the enclosure frame and the solar cell at the module periphery (outermost row) is preferably 0.1 to 3.0 mm, more preferably 0.1 to 1.0 mm. If the frame spacing is too narrow, the frame may overlap the solar cell to invite a shadow loss, resulting in a lowering of module conversion efficiency. If the frame spacing is too broad, the packing density of solar cells relative to the area of the solar cell module may be reduced, resulting in a lowering of module conversion efficiency. It is noted that tab wires may be connected with solder or the like by the standard technique.

Next, FIG. 3 illustrates an exemplary interconnection of an overall conventional solar cell module, and FIG. 4 illustrates an exemplary interconnection of an overall solar cell module according to the invention. In the illustrated example, solar cells are arranged in plural rows of 4 cells by 4 cells and connected in series. Illustrated in FIGS. 3 and 4 are first solar cells 1 having a first conductivity type substrate, second solar cells 2 having a second conductivity type substrate, termini 5 of first polarity electrodes, termini 6 of second polarity electrodes, and an enclosure frame 7. It is appreciated from a comparison between FIGS. 3 and 4 that the inventive solar cell module has a higher packing density of cells relative to the module area than the conventional solar cell module.

In the preferred embodiment, the solar cell module includes a section wherein the first and second solar cells are connected in series. In the series connection section, the number of first solar cells having first conductivity type substrate is preferably 50% to 70%, more preferably 50% to 60%, and the number of second solar cells having second conductivity type substrate is preferably 30% to 50%, more preferably 40% to 50%. If the number of either one of first and second solar cells is extremely high, then the series connection wiring taking advantage of the invention may be impossible.

Moreover, a difference in short-circuit current density between the first and second solar cells is preferably up to 20%, more preferably up to 10%. With a too much difference in short-circuit current density, the solar cell module has a short-circuit current density which may be limited to the lowest short-circuit current density among the series connected cells.

### EXAMPLE

Example and Comparative Example are given below by way of illustration, but the invention is not limited thereto. In Examples below, characteristics (short-circuit current density, open voltage, fill factor, and conversion efficiency) of a solar cell and a solar cell module were measured using a solar simulator (light intensity 1 kW/m², spectrum AM 1.5 global).

### Example 1

In this Example, a solar cell module of the structure shown in FIG. 4 was fabricated as follows.

Solar cells were prepared using n-type single crystal silicon substrate as the first conductivity type substrate and p-type single crystal silicon substrate as the second conductivity type substrate. All the cells thus prepared had a size of 100 mm square.

The average characteristics of the solar cells using n-type substrate included a short-circuit current density of 35.1 mA/cm², an open voltage of 0.619 V, a fill factor of 78.3%, and a conversion efficiency of 17.0%.

The average characteristics of the solar cells using p-type substrate included a short-circuit current density of 35.1 mA/cm², an open voltage of 0.618 V, a fill factor of 78.5%, and a conversion efficiency of 17.0%.

Since solar cells were to be connected in series to construct a solar cell module, the solar cells were adjusted, during preparation, so as to have an equivalent short-circuit current density among other characteristics.

Using the solar cells of two types in an array of 4×4 = 16, a solar cell module was fabricated within the scope of the invention. The spacing between solar cells was 0.5 mm, the spacing between the cell at the module periphery and the frame was 1.0 mm, and the frame had a width of 5.0 mm. While tab wires projected 3.0 mm from the cell located at the module periphery in the bus-bar direction, they were connected to bus-bar electrodes of the next row.

The module thus fabricated had a size of 413.5 mm long by 419.5 mm wide including the frame.

The solar cell module thus fabricated was characterized by a short-circuit current flow of 3.50 A, an open voltage of 9.88 V, a fill factor of 77.9%, and a conversion efficiency of 15.5%.

Notably, no failure at the cell edge was observed although the spacing between solar cells was 0.5 mm.

### Comparative Example 1

In Comparative Example, a solar cell module of the structure shown in FIG. 3 was fabricated as follows.

As the solar cells, only those cells using the first conductivity type substrate in Example 1 were used in an array of 4x4 = 16. With respect to the spacing between solar cells, the spacing for interconnection by tab wires in bus-bar direction was 4.0 mm, and the spacing without interconnection by tab wires was 0.5 mm. The remaining parameters including the spacing between the cell at the module periphery and the frame, the frame width, and the projection of tab wires from the cell at the module periphery in the bus-bar direction were the same as in Example 1.

The module thus fabricated had a size of 413.5 mm long by 430 mm wide including the frame.

The solar cell module fabricated in Comparative Example was characterized by a short-circuit current flow of 3.51 A, an open voltage of 9.90 V, a fill factor of 77.4%, and a conversion efficiency of 15.2%.

### PARTS LIST

- 1: first solar cell using first conductivity type substrate
- 2: second solar cell using second conductivity type substrate
- 3: bus-bar electrode
- 4: tab wire
- 5: terminus of first polarity electrode
- 6: terminus of second polarity electrode
- 7: enclosure frame

## Claims

1. A solar cell module comprising first solar cells (1) comprising a first conductivity type substrate which is n-type single crystal silicon substrate having a thickness of 100 to 300 µm, having a light-receiving surface and a non-light-receiving surface, and having an impurity diffusion layer forming a p-n junction on the light-receiving surface by the diffusion of Group III elements on the light-receiving surface, and electrodes (3) of opposite polarity formed on the light-receiving and non-light-receiving surfaces, respectively, and second solar cells (2) comprising a second conductivity type substrate which is p-type single crystal silicon substrate having a thickness of 100 to 300 µm, having a light-receiving surface and a non-light-receiving surface, and having an impurity diffusion layer forming a p-n junction on the light-receiving surface by the diffusion of Group V elements on the light-receiving surface, and electrodes (3) of opposite polarity formed on the light-receiving and non-light-receiving surfaces, respectively,
wherein the impurity diffusion layers of the n-type single crystal silicon substrate and the p-type single crystal silicon substrate have a thickness of 0.1 to 3.0 µm, respectively, wherein all the first and second solar cells have the same size square shape,
wherein the first solar cells (1) and the second solar cells (2) have an equivalent short-circuit current density, and a difference in short-circuit current density between the first and second solar cells is up to 20%, and
wherein the first solar cells (1) and the second solar cells (2) are alternately arranged and are connected in series by connecting the electrodes (3) on the light-receiving surface of the first solar cells and the second solar cells to each other and the electrodes (3) on the non-light-receiving surface of the first solar cells (1) and the second solar cells (2) to each other with tab wires (4) without a bend.

2. The solar cell module of claim 1, wherein the solar cells are arranged at a spacing of 0.1 mm to 3.0 mm.

3. The solar cell module of claim 1 or 2 wherein the n-type single crystal silicon substrate and the p-type single crystal silicon substrate have thicknesses of 150 to 250 µm.

4. The solar cell module of any one of claims 1 to 3 wherein the impurity diffusion layers of the n-type single crystal silicon substrate and the p-type single crystal silicon substrate have thicknesses of 0.5 to 2.0 µm.

5. The solar cell module of any one of claims 1 to 4, wherein the n-type single crystal silicon substrate and the p-type single crystal silicon substrate have resistivities of 0.1 to 5 Ω·cm.

6. The solar cell module of any one of claims 1 to 5, wherein the difference in short-circuit current density between the first and second solar cells is up to 10%.

7. A method for manufacturing a solar cell module, comprising steps of:
preparing a plurality of first solar cells (1) comprising a first conductivity type substrate which is n-type single crystal silicon substrate having a thickness of 100 to 300 µm, having a light-receiving surface and a non-light-receiving surface, and having an impurity diffusion layer forming a p-n junction on the light-receiving surface by the diffusion of Group III elements on the light-receiving surface, and electrodes (3) of opposite polarity formed on the light-receiving and non-light-receiving surfaces, respectively, and a plurality of second solar cells (2) comprising a second conductivity type substrate which is p-type single crystal silicon substrate having a thickness of 100 to 300 µm, having a light-receiving surface and a non-light-receiving surface, and having an impurity diffusion layer forming a p-n junction on the light-receiving surface by the diffusion of Group V elements on the light-receiving surface, and electrodes (3) of opposite polarity formed on the light-receiving and non-light-receiving surfaces, respectively,
wherein the impurity diffusion layers of the n-type single crystal silicon substrate and the p-type single crystal silicon substrate have a thickness of 0.1 to 3.0 µm, respectively, wherein all the first and second solar cells have same size square shape, wherein the first solar cells and the second solar cells have an equivalent short-circuit current density, and a difference in short-circuit current density between the first and second solar cells is up to 20%,
arranging the first solar cells (1) and the second solar cells (2) alternately, and
connecting the electrodes (3) on the light-receiving surface of the first solar cells (1) and the second solar cells to each other and the electrodes (3) on the non-light-receiving surface of the first solar cells and the second solar cells to each other with tab wires (4) without a bend, whereby the first and second solar cells (1,2) are connected in series.

8. A method of claim 7, wherein the solar cells are arranged at a spacing of 0.1 mm to 3.0 mm.

9. A method of claim 7 or 8, wherein the n-type single crystal silicon substrate and the p-type single crystal silicon substrate have thicknesses of 150 to 250 µm.

10. The method of any one of claims 7 to 9, wherein the impurity diffusion layers of the n-type single crystal silicon substrate and the p-type single crystal silicon substrate have thicknesses of 0.5 to 2.0 µm.

11. A method of any one of claims 7 to 10, wherein the n-type single crystal silicon substrate and the p-type single crystal silicon substrate have a resistivity of 0.1 to 5 Ω·cm, respectively.

12. A method of any one of claims 7 to 11, wherein the difference in short-circuit current density between the first and second solar cells is up to 10%.

## Patentansprüche

1. Solarzellenmodul mit ersten Solarzellen (1), die ein Substrat mit einem ersten Leitfähigkeitstyp, das ein n-Typ-Einkristallsiliciumsubstrat ist, das eine Dicke von 100 bis 300 µm aufweist, eine lichtaufnehmende Oberfläche und eine nicht-lichtaufnehmende Oberfläche aufweist, und das eine Fremdstoffdiffusionsschicht aufweist, die durch die Diffusion von Gruppe-III-Elementen auf der lichtaufnehmenden Oberfläche einen p-n-Übergang auf der lichtaufnehmenden Oberfläche ausbildet, und Elektroden (3) mit entgegengesetzter Polarität umfassen, die auf der lichtaufnehmenden bzw. nicht-lichtaufnehmenden Oberfläche ausgebildet sind, und zweiten Solarzellen (2), die ein Substrat mit einem zweiten Leitfähigkeitstyp, das ein p-Typ-Einkristallsiliciumsubstrat mit einer Dicke von 100 bis 300 µm ist, das eine lichtaufnehmende Oberfläche und eine nicht-lichtaufnehmende Oberfläche aufweist, und das eine Fremdstoffdiffusionsschicht aufweist, die durch die Diffusion von Gruppe-V-Elementen auf der lichtaufnehmenden Oberfläche einen p-n-Übergang auf der lichtaufnehmenden Oberfläche ausbildet, und Elektroden (3) mit entgegengesetzter Polarität umfassen, die auf der lichtaufnehmenden bzw. nicht-lichtaufnehmenden Oberfläche ausgebildet sind,
wobei die Fremdstoffdiffusionsschichten des n-Typ-Einkristallsiliciumsubstrats und des p-Typ-Einkristallsiliciumsubstrats jeweils eine Dicke von 0,1 bis 3,0 µm aufweisen, wobei alle ersten und zweiten Solarzellen dieselbe Größe und quadratische Form aufweisen,
wobei die ersten Solarzellen (1) und die zweiten Solarzellen (2) eine äquivalente Kurzschlussstromdichte aufweisen und eine Differenz in der Kurzschlussstromdichte zwischen den ersten und zweiten Solarzellen bis zu 20 % beträgt, und
wobei die ersten Solarzellen (1) und die zweiten Solarzellen (2) abwechselnd angeordnet sind und in Serie verbunden sind, indem die Elektroden (3) auf der lichtaufnehmenden Oberfläche der ersten Solarzellen und die zweiten Solarzellen miteinander verbunden sind und die Elektroden (3) auf der nicht-lichtaufnehmenden Oberfläche der ersten Solarzellen (1) und der zweiten Solarzellen (2) miteinander mit Tabbing-Drähten (4) ohne eine Biegung verbunden sind.

2. Solarzellenmodul nach Anspruch 1, wobei
die Solarzellen mit einer Beabstandung von 0,1 mm bis 3,0 mm angeordnet sind.

3. Solarzellenmodul nach Anspruch 1 oder 2, wobei das n-Typ-Einkristallsiliciumsubstrat und das p-Typ-Einkristallsiliciumsubstrat Dicken von 150 bis 250 µm aufweisen.

4. Solarzellenmodul nach einem der Ansprüche 1 bis 3, wobei die Fremdstoffdiffusionsschichten des n-Typ-Einkristallsiliciumsubstrats und des p-Typ-Einkristallsiliciumsubstrats Dicken von 0,5 bis 2,0 µm aufweisen.

5. Solarzellenmodul nach einem der Ansprüche 1 bis 4, wobei das n-Typ-Einkristallsiliciumsubstrat und das p-Typ-Einkristallsiliciumsubstrat spezifische Widerstände von 0,1 bis 5 Ω . cm aufweist.

6. Solarzellenmodul nach einem der Ansprüche 1 bis 5, wobei die Differenz in der Kurzschlussstromdichte zwischen den ersten und zweiten Solarzellen bis zu 10 % beträgt.

7. Verfahren zum Herstellen eines Solarzellenmoduls, das folgende Schritte umfasst:
Herstellen einer Vielzahl von ersten Solarzellen (1), die ein Substrat mit einem ersten Leitfähigkeitstyp, das ein n-Typ-Einkristallsiliciumsubstrat ist, das eine Dicke von 100 bis 300 µm aufweist, eine lichtaufnehmende Oberfläche und eine nicht-lichtaufnehmende Oberfläche aufweist, und eine Fremdstoffdiffusionsschicht aufweist, die durch die Diffusion von Gruppe-III-Elementen auf der lichtaufnehmenden Oberfläche einen p-n-Übergang auf der lichtaufnehmenden Oberfläche ausbildet, und Elektroden (3) mit entgegengesetzter Polarität umfassen, die auf der lichtaufnehmenden bzw. nicht-lichtaufnehmenden Oberfläche ausgebildet werden, und einer Vielzahl von zweiten Solarzellen (2), die ein Substrat mit einem zweiten Leitfähigkeitstyp, das ein p-Typ-Einkristallsiliciumsubstrat mit einer Dicke von 100 bis 300 µm ist, das eine lichtaufnehmende Oberfläche und eine nicht-lichtaufnehmende Oberfläche aufweist, und eine Fremdstoffdiffusionsschicht aufweist, die durch die Diffusion von Gruppe-V-Elementen auf der lichtaufnehmenden Oberfläche einen p-n-Übergang auf der lichtaufnehmenden Oberfläche ausbildet, und Elektroden (3) mit entgegengesetzter Polarität umfassen, die auf der lichtaufnehmenden bzw. nicht-lichtaufnehmenden Oberfläche ausgebildet werden,
wobei die Fremdstoffdiffusionsschichten des n-Typ-Einkristallsiliciumsubstrats und des p-Typ-Einkristallsiliciumsubstrats jeweils eine Dicke von 0,1 bis 3,0 µm aufweisen, wobei alle ersten und zweiten Solarzellen dieselbe Größe und quadratische Form aufweisen, wobei die ersten Solarzellen und die zweiten Solarzellen eine äquivalente Kurzschlussstromdichte aufweisen und eine Differenz in der Kurzschlussstromdichte zwischen den ersten und zweiten Solarzellen bis zu 20 % beträgt,
abwechselndes Anordnen der ersten Solarzellen (1) und der zweiten Solarzellen (2) und
Verbinden der Elektroden (3) auf der lichtaufnehmenden Oberfläche der ersten Solarzellen (1) und der zweiten Solarzellen miteinander und der Elektroden (3) auf der nicht-lichtaufnehmenden Oberfläche der ersten Solarzellen und der zweiten Solarzellen miteinander mit Tabbing-Drähten (4) ohne eine Biegung, wodurch die ersten und zweiten Solarzellen (1,2) in Serie verbunden sind.

8. Verfahren nach Anspruch 7, wobei die Solarzellen mit einer Beabstandung von 0,1 mm bis 3,0 mm angeordnet sind.

9. Verfahren nach Anspruch 7 oder 8, wobei das n-Typ-Einkristallsiliciumsubstrat und das p-Typ-Einkristallsiliciumsubstrat Dicken von 150 bis 250 µm aufweisen.

10. Verfahren nach einem der Ansprüche 7 bis 9, wobei die Fremdstoffdiffusionsschichten des n-Typ-Einkristallsiliciumsubstrats und des p-Typ-Einkristallsiliciumsubstrats Dicken von 0,5 bis 2,0 µm aufweisen.

11. Verfahren nach einem der Ansprüche 7 bis 10, wobei das n-Typ-Einkristallsiliciumsubstrat und das p-Typ-Einkristallsiliciumsubstrat einen spezifischen Widerstand von 0,1 bis 5 Ω ▪ cm aufweisen.

12. Verfahren nach einem der Ansprüche 7 bis 11, wobei die Differenz in der Kurzschlussstromdichte zwischen den ersten und zweiten Solarzellen bis zu 10 % beträgt.

## Revendications

1. Module de cellules solaires comprenant des premières cellules solaires (1) comprenant un substrat de premier type de conductivité qui est un substrat de silicium monocristallin de type n ayant une épaisseur de 100 à 300 µm, ayant une surface réceptrice de lumière et une surface non réceptrice de lumière, et ayant une couche de diffusion d'impureté formant une jonction p-n sur la surface réceptrice de lumière par la diffusion d'éléments du groupe III sur la surface réceptrice de lumière, et des électrodes (3) de polarité opposée formées sur les surfaces réceptrice de lumière et non réceptrice de lumière, respectivement, et des secondes cellules solaires (2) comprenant un substrat de second type de conductivité qui est un substrat de silicium monocristallin de type p ayant une épaisseur de 100 à 300 µm, ayant une surface réceptrice de lumière et une surface non réceptrice de lumière, et ayant une couche de diffusion d'impureté formant une jonction p-n sur la surface réceptrice de lumière par la diffusion d'éléments du groupe V sur la surface réceptrice de lumière, et des électrodes (3) de polarité opposée formées sur les surfaces réceptrice de lumière et non réceptrice de lumière, respectivement,
dans lequel les couches de diffusion d'impureté du substrat de silicium monocristallin de type n et du substrat de silicium monocristallin de type p ont une épaisseur de 0,1 à 3,0 µm, respectivement, dans lequel toutes les première et seconde cellules solaires ont la forme carrée de même taille,
dans lequel les premières cellules solaires (1) et les secondes cellules solaires (2) ont une densité de courant de court-circuit équivalente, et une différence de densité de courant de court-circuit entre les premières et secondes cellules solaires peut atteindre 20 %, et
dans lequel les premières cellules solaires (1) et les secondes cellules solaires (2) sont agencées de manière alternée et sont connectées en série en connectant les électrodes (3) sur la surface réceptrice de lumière des premières cellules solaires et des secondes cellules solaires les unes aux autres et les électrodes (3) sur la surface non réceptrice de lumière des premières cellules solaires (1) et des secondes cellules solaires (2) les unes aux autres avec des languettes de connexion (4) sans coude.

2. Module de cellules solaires selon la revendication 1, dans lequel les cellules solaires sont agencées à un espacement de 0,1 mm à 3,0 mm.

3. Module de cellules solaires selon la revendication 1 ou 2, dans lequel le substrat de silicium monocristallin de type n et le substrat de silicium monocristallin de type p ont des épaisseurs de 150 à 250 µm.

4. Module de cellules solaires selon l'une quelconque des revendications 1 à 3, dans lequel les couches de diffusion d'impureté du substrat de silicium monocristallin de type n et du substrat de silicium monocristallin de type p ont des épaisseurs de 0,5 à 2,0 µm.

5. Module de cellules solaires selon l'une quelconque des revendications 1 à 4, dans lequel le substrat de silicium monocristallin de type n et le substrat de silicium monocristallin de type p ont des résistivités de 0,1 à 5 Ω cm.

6. Module de cellules solaires selon l'une quelconque des revendications 1 à 5, dans lequel la différence de densité de courant de court-circuit entre les premières et secondes cellules solaires peut atteindre 10 %.

7. Procédé de fabrication d'un module de cellules solaires, comprenant les étapes consistant à :
préparer une pluralité de premières cellules solaires (1) comprenant un substrat de premier type de conductivité qui est un substrat de silicium monocristallin de type n ayant une épaisseur de 100 à 300 µm, ayant une surface réceptrice de lumière et une surface non réceptrice de lumière, et ayant une couche de diffusion d'impureté formant une jonction p-n sur la surface réceptrice de lumière par la diffusion d'éléments du groupe III sur la surface réceptrice de lumière, et des électrodes (3) de polarité opposée formées sur les surfaces réceptrice de lumière et non réceptrice de lumière, respectivement, et une pluralité de secondes cellules solaires (2) comprenant un substrat de second type de conductivité qui est un substrat de silicium monocristallin de type p ayant une épaisseur de 100 à 300 µm, ayant une surface réceptrice de lumière et une surface non réceptrice de lumière, et ayant une couche de diffusion d'impureté formant une jonction p-n sur la surface réceptrice de lumière par la diffusion d'éléments du groupe V sur la surface réceptrice de lumière, et des électrodes (3) de polarité opposée formées sur les surfaces réceptrice de lumière et non réceptrice de lumière, respectivement,
dans lequel les couches de diffusion d'impureté du substrat de silicium monocristallin de type n et du substrat de silicium monocristallin de type p ont une épaisseur de 0,1 à 3,0 µm, respectivement, dans lequel toutes les premières et secondes cellules solaires ont la forme carrée même de taille, dans lequel les premières cellules solaires et les secondes cellules solaires ont une densité de courant de court-circuit équivalente, et une différence de densité de courant de court-circuit entre les premières et secondes cellules solaires peut atteindre 20 %,
agencer les premières cellules solaires (1) et les secondes cellules solaires (2) de manière alternée, et
connecter les électrodes (3) sur la surface réceptrice de lumière des premières cellules solaires (1) et des secondes cellules solaires les unes aux autres et les électrodes (3) sur la surface non réceptrice de lumière des premières cellules solaires et des secondes cellules solaires les unes aux autres avec des languettes de connexion (4) sans coude, de telle sorte que les premières et secondes cellules solaires (1, 2) sont connectées en série.

8. Procédé selon la revendication 7, dans lequel les cellules solaires sont agencées à un espacement de 0,1 mm à 3,0 mm.

9. Procédé selon la revendication 7 ou 8, dans lequel le substrat de silicium monocristallin de type n et le substrat de silicium monocristallin de type p ont des épaisseurs de 150 à 250 µm.

10. Procédé selon l'une quelconque des revendications 7 à 9, dans lequel les couches de diffusion d'impureté du substrat de silicium monocristallin de type n et du substrat de silicium monocristallin de type p ont des épaisseurs de 0,5 à 2,0 µm.

11. Procédé selon l'une quelconque des revendications 7 à 10, dans lequel le substrat de silicium monocristallin de type n et le substrat de silicium monocristallin de type p ont une résistivité de 0,1 à 5 Ω cm, respectivement.

12. Procédé selon l'une quelconque des revendications 7 à 11, dans lequel la différence de densité de courant de court-circuit entre les premières et secondes cellules solaires va jusqu'à 10 %.
